# EUROPÄISCHE PATENTSCHRIFT

(11) **EP 1 269 814 B1**
(45) Veröffentlichungstag und Bekanntmachung des Hinweises auf die Patenterteilung: **23.11.2005**
(21) Anmeldenummer: 01919138.6
(22) Anmeldetag: 21.02.2001
(51) Int. Cl.: H05K 13/04

(54) **VORRICHTUNG UND VERFAHREN ZUM BESTÜCKEN VON SUBSTRATEN MIT ELEKTRISCHEN BAUELEMENTEN**
DEVICE AND METHOD FOR PLACING ELECTRIC COMPONENTS ON SUBSTRATES
DISPOSITIF ET PROCEDE POUR METTRE EN PLACE DES COMPOSANTS ELECTRONIQUES SUR DES SUBSTRATS

(30) Priorität: 31.03.2000 DE 10016134
(43) Veröffentlichungstag der Anmeldung: 02.01.2003
(73) Patentinhaber: SIEMENS AKTIENGESELLSCHAFT, 80333 München (DE)
(72) Erfinder: MEHDIANPOUR, Mohammad, 81829 München (DE); ROHM, Rainer, 81477 München (DE)
(86) Internationale Anmeldenummer: PCT/DE2001/000680
(87) Internationale Veröffentlichungsnummer: WO 2001/076343

(56) Entgegenhaltungen:
- EP-A- 0 779 777
- US-A- 4 875 285
- US-A- 4 910 864

## Beschreibung

Die Erfindung bezieht sich auf eine Vorrichtung zum Bestücken von Substraten mit elektrischen Bauelementen, wobei die Substrate auf zumindest einer linearen Transportstrecke transportierbar und in zumindest einem Bestückfeld der Transportstrecke fixierbar sind,
wobei seitlich der Transportstrecke Stellplätze für Zuführeinheiten für die Bauelemente derart aneinandergereiht sind, daß Abholplätze der Bauelemente zumindest annähernd in einer Reihe angeordnet sind,
wobei an einem Chassis der Vorrichtung zumindest eine Längsführung angebracht ist, an der ein querstehender Positionierarm verfahrbar ist, entlang dem ein die Bauelemente handhabender Bestückkopf verfahrbar ist

Durch die JP 9-321491 ist eine Bestückvorrichtung für Substrate bekannt geworden, bei der zwei Bestückköpfe zu beiden Seiten eines Führungsbalkens linear verfahrbar sind, der sich quer zur Transportstrecke für die Substrate erstreckt. Unter den Greifern der Bestückköpfe liegen zwei Reihen von Abholplätzen der einander entgegengesetzt gerichteten und stirnseitig eng benachbarten Zuführeinrichtungen. Diese Anordnung hat den Nachteil, daß beim Bestücken das Substrat in der anderen Koordinatenrichtung bewegt werden muß. Infolge der zunehmenden Miniaturisierung der Bauelemente steigen die Anforderungen an die Abholgenauigkeit. Die auf einer festen Bahn geführten Greifer können einer transversalen Abweichung der Abhollage im Gegensatz zu einem zweiachsig verfahrbaren Bestückkopf nicht folgen.

Eine derartige Vorrichtung ist z.B. durch die US 5,002,448 bekannt geworden. Danach sind zwei einander entgegenragende Positionierarme so lang gehalten, daß sie beide das gesamte Bestückfeld sowie die Abholplätze überdecken. Die Zuführeinheiten bestehen aus flachen Modulen, die in der Transportrichtung der Substrate derart aneinander gereiht sind, daß ihre Abholplätze in der Nähe des Bestückfeldes liegen.

Derartige Zuführmodule sind in der Regel als Fördereinrichtungen für die in Gurten aufgenommenen Bauelemente ausgebildet, die an den Abholplatz gefördert und dort in einer definierten Lage bereitgestellt werden, die sich anhand von Positionsmarken der einzelnen Module ermitteln läßt.

Im Gegensatz zu Vorrichtungen, bei denen die Substrate unter einer festen Bestückposition verschiebbar sind, hat die Verwendung eines X-Y- verfahrbaren Positionierkopfes den Vorteil, daß es sich hier bei dem Positioniersystem um einen mehrachsigen flexibel nutzbaren Roboter handelt, der mit einer Vielzahl von Funktionen und Hilfsfunktionen ausgestattet werden kann. Ein besonderer Vorteil besteht darin, daß sich der Bestückkopf auch beim Abholen der Bauelemente an die tatsächliche Abhollage der Bauelemente in beiden Koordinatenrichtungen feinstufig annähern kann, was insbesondere bei den miniaturisierten Bauelementen von erheblicher Bedeutung ist.

Durch die Anordnung der Abholplätze in der Nähe der Transportstrecke können die Verfahrwege des Bestückkopfes kurz gehalten werden, was sich günstig auf die Stückleistung auswirkt. Ein Nachteil dieser Anordnung besteht darin, daß der schnell verfahrbare Positionierarm aus schwingungstechnischen Gründen in Anpassung auf die Länge des Bestückfeldes möglichst kurz gehalten werden soll, so daß die Einbaulänge fürdie Zuführmodule und damit die Anzahl der Stellplätze für die Zuführmodule entsprechend begrenzt ist.

US-A-4910864 beschreibt eine Vorrichtung zum Bestücker von Substraten mit elektrischen Bauelementen mit dem im erster Teil des vorliegenden Anspruchs 1 genannten Merkmalen und ein Verfahren zum Betreiben dieser Vorrichtung.

Der Erfindung liegt die Aufgabe zugrunde, die Anzahl der Stellplätze zu erhöhen.

Diese Aufgabe wird durch die Erfindung gemäß Anspruch 1 gelöst.

Durch das Aneinanderreihen der Zuführeinheiten quer zur Transportstrecke ist es möglich, die Einbaulänge zu vergrößern und dementsprechend die Anzahl der Stellplätze zu erhöhen. Dazu muß lediglich die stationäre Längsführung verlängert werden. Der Positionierarm kann in seiner Länge auf den maximalen Verfahrweg über dem Substrat beschränkt werden. Eine solche Anordnung eignet sich besonders für Vorrichtungen mit einer geringeren Stückleistung, bei denen eine große Vielfalt der bereitzustellenden Bauelemente gewünscht ist.

Dabei ist es möglich, die häufig benötigten Bauelemente in der Nähe des Bestückfeldes anzuordnen und die selten benötigten Bauelemente im äußeren Abholbereich. Bei Verwendung eines Revolverbestückkopfes kann in einem Abholzyklus eine große Anzahl der Bauelemente aufgenommen werden, so daß der längere Verfahrweg des Kopfes nur zu einer relativ geringen Verzögerung führt.

Erfindungsgemäß kann durch die doppelreihige Anordnung der Abholplätze der Verfahrweg verkürzt oder die Anzahl der Stellplätze gesteigert werden.

Außerdem wird der Verfahrweg des Bestückkopfes zwischen den beiden Abholreihen kurz gehalten.

Durch Anordnung der Abholplätze im Mittelbereich des Bestückfeldes nach Anspruch 2 wird der mittlere Verfahrweg zwischen den Bestückplätzen und den Abholplätzen verringert.

Durch die Weiterbildung nach Anspruch 3 kann die Anzahl der Stellplätze verdoppelt werden.

Durch die Anordnung nach Anspruch 4 kann die Länge des Positionierarmes kurz gehalten werden. Die Linearführung kann ohne kinematische Nachteile in einem Stück beide Abholbereiche und das Bestückfeld überdecken.

Durch Weiterbildung nach Anspruch 5 läßt sich die Stückleistung mit geringem Mehraufwand verdoppeln, indem die beiden Bestückköpfe alternierend bestücken bzw. abholen. Insbesondere bei der Verwendung des Revolver-Bestückkopfes nach Anspruch 8 dauert die Bestückphase aufgrund der höheren Positioniergenauigkeit und der größeren Verfahrwege in zwei Koordinatenrichtungen länger als die Abholphase, so daß der längere Verfahrweg zeitlich voll kompensiert wird.

Bei der Vorrichtung nach Anspruch 7 kann die Anzahl der Zuführeinheiten und damit die Anzahl der bereitgestellten Bauelementetypen erheblich erhöht werden.

Das Verfahren nach Anspruch 8 verkürzt insbesondere bei einem Revolverkopf mit großer Aufnahmekapazität an Bauelementen in Verbindung mit der doppelreihigen Anordnung die Verfahrzeit, da bei einer derartigen Verfahrschleife der Anfang und das Ende der Abholvorgänge in der Nähe des Bestückfeldes liegen können.

Im folgenden wird die Erfindung anhand eines in der Zeichnung dargestellten Ausführungsbeispieles näher erläutert.
- Figur 1: zeigt schematisiert eine Seitenansicht einer Vorrichtung zum Bestücken von Substraten mit elektrischen Bauelementen,
- Figur 2: eine Draufsicht auf die Vorrichtung auf Figur 1.

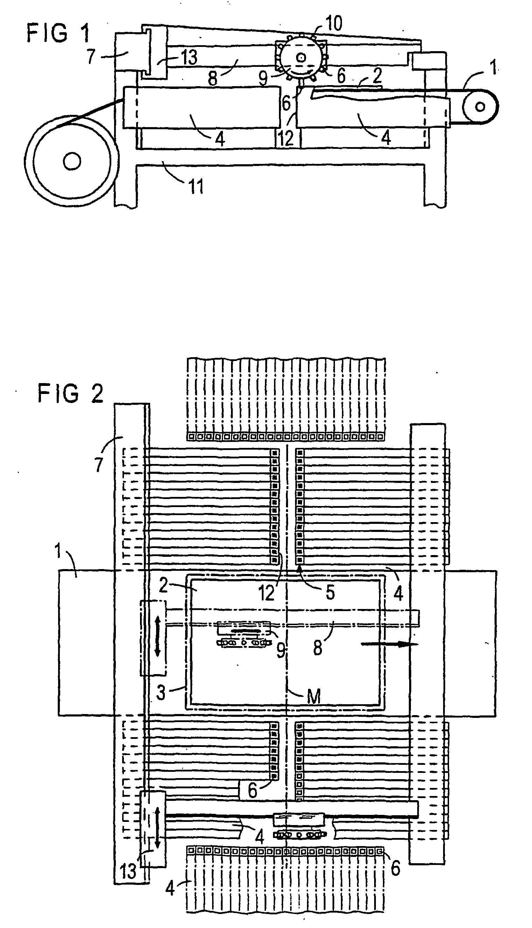

Nach den Figuren 1 und 2 weist die Vorrichtung eine lineare Transportstrecke 1 für Substrate 2 in Form von Leiterplatten auf, die in einem Bestückfeld 3 der Transportstrecke 1 fixierbar sind. Seitlich der Transportstrecke 1 sind Stellplätze für schmale modulare Zuführeinheiten 4 wechselbar aneinandergereiht, die in der Nähe ihrer Stirnseiten 12 Abholplätze 5 für elektronische Bauelemente 6 aufweisen. Die Zuführeinheiten 4 stehen parallel zur Transportstrecke 1 und die Reihe der Abholplätze 5 erstreckt sich senkrecht dazu. Auf jeder Seite der Transportstrecke 1 sind zwei zueinander parallele Reihen der sich einander gegenüberstehenden Zuführeinheiten 4 angesetzt, deren Abholplätze 5 an den einander zugewandten Stirnseiten 12 mit geringem Abstand zu beiden Seiten einer gemeinsamen Mittelachse M angeordnet sind, die sich durch die Mitte des Bestückfeldes 3 erstreckt.

Auf einer Seite des Bestückfeldes 3 ist an einem Chassis 11 der Vorrichtung eine Längsführung 7 abgestützt, die sich sich senkrecht zur Transportstrecke 1 erstreckt. An der Längsführung 7 ist ein querstehender Positionierarm 8 verfahrbar, entlang dem ein Bestückkopf 9 zum Handhaben der Bauelemente 6 verfahrbar ist. Dieser ist als Revolverkopf ausgebildet und weist eine Vielzahl von sternförmig abstehenden, als Saugpipetten ausgebildeten Greifern 10 zur Aufnahme einer entsprechend großen Anzahl der Bauelemente 6 auf. Der Positionierarm 8 überdeckt die volle Länge des Substrats 2 in der Transportrichtung. Die Längsführung 7 erstreckt sich über die Abholbereiche zu beiden Seiten der Transportstrecke 1 und über die Breite des Bestückfeldes 3 , so daß der Bestückkopf 9 die Bauelemente (6) sämtlicher Abholplätze 5 erreichen und auf dem Substrat 2 absetzen kann.

Auf der Längsführung 7 kann ein weiterer, strichpunktiert angedeuteter Positionierarm 8 mit einem weiteren Bestückkopf 9 angesetzt werden, wobei jeder der beiden Bestückköpfe 9 nur auf einen der Abholbereiche auf einer Seite der Transportstrecke zugreift. Die beiden Bestückköpfe 9 können so betrieben werden, daß wechselweise jeweils einer Bauelemente 6 abholt und der andere die zuvor abgeholten Bauelemente 6 auf das Substrat 2 aufsetzt.

Auf den dem Bestückfeld abgewandten Außenseite der Reihe der-Zuführeinheiten können zusätzliche Stellplätze für zusätzliche strichpunktiert angedeutete Zuführeinheiten angeordnet werden, die sich quer zur Transportrichtung der Substrate erstrecken und deren Abholplätze auf ihrer dem Bestückfeld zugewandten Seite parallel zur Transportstrecke aneinander gereiht sind.

## Patentansprüche

1. Vorrichtung zum Bestücken von Substraten (2) mit elektrischen Bauelementen (6), wobei die Substrate (2) auf zumindest einer linearen Transportstrecke (1) transportierbar und in zumindest einem Bestückfeld (3) der Transportstrecke (1) fixierbar sind,
wobei seitlich der Transportstrecke (1) Stellplätze für Zuführeinheiten (4) für die Bauelemente (6) derart aneinandergereiht sind, daß die Abholplätze (5) der Bauelemente (6) zumindest annähernd in einer Reihe angeordnet sind,
wobei die Abholplätze in der Nähe einer Stirnseite (12) der Zuführeinheiten (4) angeordnet sind,
wobei an einem Chassis (11) der Vorrichtung zumindest eine Längsführung (7) angebracht ist, an der ein querstehender Positionierarm (8) verfahrbar ist, entlang dem ein die Bauelemente (6) handhabender Bestückkopf (9) verfahrbar ist,
wobei die Reihenrichtung der Zuführeinheiten (4) mit den Abholplätzen (5) senkrecht zur Transportrichtung der Substrate (2) orientiert ist und
wobei der Verfahrbereich des Bestückkopfes (9) in dieser Richtung bis zu den vom Bestückfeld (3) entferntesten Abholplätzen (5) ausgedehnt ist,
**dadurch gekennzeichnet,**
**daß** auf einer Seite der Transportstrecke (1) zwei zueinander parallele Reihen der Zuführeinheiten (4) angeordnet sind, wobei die Abholplätze (5) an den einander zugewandten Enden der Zuführeinheiten (4) beider Reihen angeordnet sind.

2. Vorrichtung nach Anspruch 1,
**dadurch gekennzeichnet,**
**daß** sich die Reihen der Abholplätze (5) zu beiden Seiten einer zur Transportrichtung senkrechten Mittelachse (M) des Bestückfeldes (3) und parallel zu dieser erstrecken.

3. Vorrichtung nach einem der Ansprüche 1 oder 2,
**dadurch gekennzeichnet,**
**daß** die Zuführeinheiten (4) zu beiden Seiten der Transportstrecke (1) angeordnet sind.

4. Vorrichtung nach einem der Ansprüche 1 bis 3,
**dadurch gekennzeichnet,**
**daß** sich die Längsführung (7) in der Reihenrichtung der Abholplätze (5) erstreckt.

5. Vorrichtung nach Anspruch 4,
**dadurch gekennzeichnet,**
**daß** an der Längsführung (7) zwei der unabhängig voneinander antreibbaren Positionierarme (8) mit je einem der Bestückköpfe (9) verschiebbar sind.

6. Vorrichtung nach einem der vorhergehenden Ansprüche,
**dadurch gekennzeichnet,**
**daß** der Bestückkopf (9) als Revolverkopf mit mehreren umlaufenden Greifern (10) zur gleichzeitigen Aufnahme mehrerer der Bauelemente (6) ausgebildet ist.

7. Vorrichtung nach einem der vorhergehenden Ansprüche,
**dadurch gekennzeichnet,**
**daß** auf zumindest einer der dem Bestückfeld (3) abgewandten Außenseiten der Stellplätze für die Zuführeinheiten (4) zusätzliche Stellplätze für zusätzliche der Zuführeinheiten (4) vorgesehen sind, die sich quer zur Transportrichtung der Substrate (2) erstrecken und deren Abholplätze (5) auf ihrer dem Bestückfeld (3) zugewandten Seite parallel zur Transportstrecke (1) aneinander gereiht sind.

8. Verfahren zum Betreiben einer Vorrichtung zum Bestücken
von Substraten (2) mit elektrischen Bauelementen nach einem der vorhergehenden Ansprüche,
wobei die Substrate (2) auf zumindest einer linearen Transportstrecke (1) transportiert und in zumindest einem Bestückfeld (3) der Transportstrecke (1) fixiert werden,
wobei seitlich der Transportstrecke (1) Zuführeinheiten (4) (4) für die Bauelemente (6) derart aneinandergereiht werden,
daß Abholplätze (5) der Bauelemente (6) zumindest annähernd in einer Reihe angeordnet sind,
wobei an einem Chassis (11) der Vorrichtung zumindest eine Längsführung (7) angebracht ist, an der ein querstehender Positionierarm (8) verfahren wird, entlang dem ein die Bauelemente (6) handhabender Bestückkopf (9) verfahren wird,
**dadurch gekennzeichnet,**
**daß** die Reihenrichtung der doppelreihigen Abholplätze (5) senkrecht zur Transportrichtung der Substrate (2) verläuft, daß der revolverartige Bestückkopf (9) beim Abholen der Bauelemente zunächst entlang einer der Reihen in einer vom Bestückfeld (3) weg führenden Verfahrbewegung eine Teilmenge der abzuholenden Bauelemente aufnimmt,
**daß** der Bestückkopf (9) sodann in einer kurzen Querbewegung zur anderen Reihe der Abholplätze (5) überwechselt und entlang dieser Reihe auf seinem Rückweg zum Bestückfeld (3) die Restmenge der Bauelemente aufnimmt.

## Claims

1. Device for assembling electrical components (6) on substrates (2), the substrates (2) being such that they can be transported on at least one linear transport section (1) and can be fixed in at least one assembly field (3) of the transport section (1),
with positioning points for feed units (4) for the components (6) being lined up at the side of the transport section (1) such that the collection points (5) of the components (6) are arranged at least approximately in a line,
with the collection points being arranged in the vicinity of a front face (12) of the feed units (4),
with at least one longitudinal guide (7) being attached to a frame (11) of the device, on which a perpendicular positioning arm (8) can be moved, along which an assembly head (9) handling the components (6) can be moved,
with the direction of the lines of feed units (4) with the collection points (5) being oriented perpendicular to the transport direction of the substrates (2) and
with the travel area of the assembly head (9) being extended in this direction to the collection points (5) furthest from the assembly field (3),
**characterized in that**
two mutually parallel lines of feed units (4) are arranged on one side of the transport section (1), with the collection points (5) being arranged at the ends of the feed units (4) of the two lines facing each other.

2. Device according to claim 1,
**characterized in that** the lines of collection points (5) extend on both sides of a central axis (M) of the assembly field (3) perpendicular to the transport direction and parallel to this.

3. Device according to one of claims 1 or 2,
**characterized in that** the feed units (4) are arranged on both sides of the transport section (1).

4. Device according to one of claims 1 to 3,
**characterized in that** the longitudinal guide (7) extends in the direction of the lines of collection points (5).

5. Device according to claim 4,
**characterized in that** two of the positioning arms (8) that can be driven independently of each other can be displaced on the longitudinal guide (7) with one of the assembly heads (9) each.

6. Device according to one of the preceding claims,
**characterized in that** the assembly head (9) is configured as a revolving head with a plurality of rotating grippers (10) to hold a plurality of the components (6) simultaneously.

7. Device according to one of the preceding claims,
**characterized in that** additional positioning points for additional feed units (4) are provided on at least one of the outer sides of the positioning points for the feed units (4) facing away from the assembly field (3), extending perpendicular to the transport direction of the substrates (2), the collection points (5) of which are lined up parallel to the transport section (1) on their side facing the assembly field (3).

8. Method for operating a device for assembling electrical components on substrates (2) according to one of the preceding claims,
with the substrates (2) being transported on at least one linear transport section (1) and being fixed in at least one assembly field (3) in the transport section (1),
with feed units (4) for the components (6) being lined up at the side of the transport section (1) such that collection points (5) for the components (6) are arranged at least approximately in a line,
with at least one longitudinal guide (7) being attached to a frame (11) of the device, on which a perpendicular positioning arm (8) is moved, along which an assembly head (9) handling the components (6) is moved,
**characterized in that**
the line direction of the two lines of collection points (5) runs perpendicular to the transport direction of the substrates (2),
during collection of the components the revolving assembly head (9) first receives a subset of the components to be collected along one of the lines in a travel movement away from the assembly field (3),
the assembly head (9) then switches in a short transverse movement to the other line of collection points (5) and receives the remaining components along this line on its way back to the assembly field (3).

## Revendications

1. Dispositif pour l'équipement de substrats (2) avec des composants (6) électriques, les substrats (2) pouvant être transportés au moins sur une voie de transport (1) linéaire et pouvant être fixés dans au moins une zone d'équipement (3) de la voie de transport (1),
des emplacements de positionnement pour des unités d'alimentation (4) en composants (6) étant alignés sur le côté de la voie de transport (1) de telle sorte que les emplacements d'enlèvement (5) des composants sont disposés au moins approximativement dans une rangée, les emplacements d'enlèvement étant disposés à proximité d'un côté avant (12) des unités d'alimentation (4),
au moins un guide longitudinal (7) étant placé sur un châssis (11) du dispositif, guide sur lequel peut être déplacé un bras de positionnement (8) disposé en travers, le long duquel une tête d'équipement (9) manipulant les composants (6) peut être déplacée,
la direction des rangées des unités d'alimentation (4) avec les emplacements d'enlèvement (5) étant orientée perpendiculairement au sens de transport des substrats (2) et la zone de déplacement de la tête d'équipement (9) étant étendue dans cette direction jusqu'aux emplacements d'enlèvement (5) les plus éloignés de la zone d'équipement (3),
**caractérisé en ce que**,
deux rangées parallèles entre elles des unités d'alimentation (4) étant disposées sur un côté de la voie de transport (1), les emplacements d'enlèvement (5) étant disposés sur les extrémités, tournées les unes vers les autres, des unités d'alimentation (4) des deux rangées.

2. Dispositif selon la revendication 1,
**caractérisé en ce que**,
les rangées des emplacements d'enlèvement (5) s'étendent des deux côtés d'un axe médian (M), perpendiculaire à la direction de transport, de la zone d'équipement (3) et parallèlement à celui-ci.

3. Dispositif selon l'une quelconque des revendications 1 ou 2,
**caractérisé en ce que**,
les unités d'alimentation (4) sont disposées des deux côtés de la voie de transport (1).

4. Dispositif selon l'une quelconque des revendications 1 à 3,
**caractérisé en ce que**,
le guide longitudinal (7) s'étend dans la direction de rangée des emplacements d'enlèvement (5).

5. Dispositif selon la revendication 4,
**caractérisé en ce que**,
deux des bras de positionnement (8) pouvant être entraînés indépendamment l'un de l'autre peuvent être déplacés avec respectivement une des têtes d'équipement (9) sur le guide longitudinal (7).

6. Dispositif selon l'une quelconque des revendications précédentes,
**caractérisé en ce que**,
la tête d'équipement (9) est conçue comme tourelle revolver avec plusieurs préhenseurs(10) rotatifs pour le logement simultané de plusieurs des composants (6).

7. Dispositif selon l'une quelconque des revendications précédentes,
**caractérisé en ce que**,
il est prévu sur au moins l'un des côtés extérieurs, opposés à la zone d'équipement (3), des emplacements de positionnement pour les unités d'alimentation (4), des emplacements de positionnement supplémentaires pour des unités d'alimentation (4) supplémentaires, qui s'étendent transversalement au sens de transport de substrats (2) et dont les emplacements d'enlèvement (5) sont alignés entre eux sur leur côté, tourné vers la zone d'équipement (3), parallèlement à la voie de transport (1).

8. Procédé pour l'exploitation d'un dispositif pour l'équipement de substrats (2) avec des composants électriques selon l'une quelconque des revendications précédentes,
les substrats (2) étant transportés sur au moins une voie de transport (1) linéaire et étant fixés dans au moins une zone d'équipement (3) de la voie de transport (1),
des unités d'alimentation (4) en composants (6) étant alignées sur le côté de la voie de transport (1) de telle sorte que des emplacements d'enlèvement (5) des composants (6) sont disposés au moins approximativement dans une rangée, au moins un guide longitudinal (7), étant placé sur un châssis (11) du dispositif, guide sur lequel est déplacé un bras de positionnement (8) placé en travers, le long duquel une tête d'équipement (9) manipulant les composants (6) est déplacée, **caractérisé en ce que**
la direction des rangées des emplacements d'enlèvement (5) à double rangée est agencée perpendiculairement au sens de transport des substrats (2), **en ce que** la tête d'équipement (9) de type revolver prend une quantité partielle des composants à enlever lors de l'enlèvement des composants d'abord le long de l'une des rangées dans un mouvement de déplacement s'éloignant de la zone d'équipement (3),
**en ce que** la tête d'équipement (9) passe ensuite dans un court mouvement transversal à l'autre rangée des emplacements d'enlèvement (5) et prend la quantité restante des composants le long de cette rangée sur son trajet de retour à la zone d'équipement (3).
